Europäisches Patentamt

European Patent Office

Office européen des brevets

(11) Publication number : **0 534 733 A1**

## (12) EUROPEAN PATENT APPLICATION

(21) Application number : **92308661.5**

(22) Date of filing : **23.09.92**

(51) Int. Cl.⁵ : **H01L 23/498, H01L 23/15**

(30) Priority : **23.09.91 US 764669**

(43) Date of publication of application :
**31.03.93 Bulletin 93/13**

(84) Designated Contracting States :
**DE FR GB**

(71) Applicant : **International Business Machines Corporation**
**Old Orchard Road**
**Armonk, N.Y. 10504 (US)**

(72) Inventor : **Chance, Dudley Augustus**
**91 Taunton Hill Road**
**Newton, Connecticut 06470 (US)**
Inventor : **Goland, David Brian**
**425 Bedford Road**
**Bedford Hills, New York 10507 (US)**
Inventor : **Dinger, Timothy Rea**
**110 North Highland Place**
**Croton-on-Hudson, New York 10520 (US)**
Inventor : **Shinde, Subhash Laxman**
**49 Truesdale Drive**
**Croton-on-Hudson, New York 10520 (US)**

(74) Representative : **Atchley, Martin John Waldegrave**
**IBM United Kingdom Limited Intellectual Property Department Hursley Park**
**Winchester Hampshire SO21 2JN (GB)**

(54) **Multilayer ceramic structure and method of fabrication.**

(57)   The present invention relates to a ceramic structure (2) and is characterised in that one of the layers (6) within the structure is formed from porous silicon dioxide.

According to a preferred embodiment of the invention at least one electrical conductor (12, 26) extends adjacent to the surface of the silicon dioxide layer.

The invention also relates to a method of fabricating a multilayer ceramic structure comprising the steps of providing a first layer of a first green precursor to a first dielectric material, forming a cavity in the first layer, disposing a body of selected material within the cavity, sealing the cavity with a second layer of a second green precursor to a second dielectric material, and sintering the multilayer structure to form a dense structure having the selected material in sintered form sealed therein.

According to the invention the method is characterised in that the selected material is a precursor to porous silicon dioxide.

According to a preferred embodiment the method of the invention includes the step of forming at least one electrical conductor adjacent to the body of selected material.

F I G. 1

The present invention relates to multilayer ceramic structures and to methods of fabrication of such structures and in particular such structures which are formed with electrical conductors between the layers.

Multilayered ceramic circuit structures which contain patterned metal layers acting as electrical conductors sandwiched between ceramic layers acting as electrical insulators are well known. These ceramic structures are formed by laminating together thin green sheets of glass particles or an admixture of glass and crystalline particles mixed with binders and on which are deposited patterns of paste containing metal particles mixed with binders for forming conductors between the ceramic green sheets. This green laminate is fired to burn off the binder materials, fired to coalesce the particles to a dense state, and further fired if necessary to crystallise the densified glass particles or to further crystallise the admixture of glass and crystalline particles to form an insulator and to coalesce the metal particles to form conducting metal lines.

Terms such as "ceramic" and "glass ceramic" are often used interchangeably in the art. To avoid confusion for the purpose of this application the following definitions will be used.

The term "ceramic" has the following meaning: an aggregate of randomly oriented crystallites wherein the interstices between crystallites may contain uncrystallised material such as glass.

The terms "coalescence" or "densification" refer to a heat treatment to reduce the density of pores in green sheets.

The term "crystallisation" refers to further heating after coalescence or densification or to heating if there is no coalescence or densification step to form crystallites from a glass.

The term "sintering" refers to the heat treatment required to form the final ceramic. Sintering of a green sheet of an admixture of glass particles and crystalline particles is a heat treatment to coalesce or densify the green sheet plus a crystallising heat treatment only if further crystallisation is required.

The term "sintering temperature" means, for a green sheet requiring crystallisation, the crystallisation temperature. The sintering temperature means, for a green sheet not requiring crystallisation, the coalescence temperature.

Structures made of ceramics requiring high temperatures for particle coalescence and densification, such as alumina, restrict the choice of co-sinterable conducting metals to high melting point metals, for example refractory metals, such as molybdenum, tungsten, platinum, palladium or a combination of these with each other or certain other metals and precludes the use of preferable electrical conductors such as gold, silver and copper which have melting points less than the alumina sintering temperature. Alumina is a good insulator, has high thermal conductivity and has good strength. The dielectric constant of alumina is about 10.

Materials often referred to as "glass-ceramics" have been intensively studied in recent years for use as structures acting as electrical circuit substrates. These ceramics generally have low dielectric constant, a low thermal coefficient of expansion which is close in value to silicon and a low sintering temperature. The low sintering temperature permits the use of low melting point metals, such as copper and noble metals, for electrical conductors. Noble metals have low resistivities comparable to copper. However, copper is less expensive and, therefore, its use substantially reduces manufacturing cost. Then an oxidisable metal, such as copper, silver or molybdenum is used as the electrical conductor, it is necessary that thermoplastic organic binder materials, contained within the green sheet used to form the ceramic and contained within the paste used to form the copper conductors, be depolymerised and burned out in an atmosphere and at a temperature whereat the metal is not substantially oxidised.

Failure to burn out binders results in less than desirable ceramic properties. For example, if the binder is not fully burned out, residual carbon is left in the sintered ceramic which modifies the ceramic dielectric constant and inhibits complete densification. With only 0.1% residual carbon content the ceramic may be black having an apparent dielectric constant greater than 1000 and, rather than being an insulator, the fired ceramic will be a semiconductor. An oxidising atmosphere is generally needed to burn out the binder.

Removal of the binder is complicated by the additional requirement that the burn-out ambient conditions should not excessively oxidise the oxidisable metal lines and planes. If the metal is excessively oxidised, the metal oxide diffuses into the ceramic and changes the dielectric properties of the ceramic. Also, when metal is excessively oxidised it expands causing stress within the green laminate which can result in delamination and cracking of the green laminate. Such cracks may not be removed by the sintering heat treatment thereby resulting in a ceramic weakened by cracks.

A semiconductor chip is commonly electrically mounted onto the multilayer packaging substrates. Generally, there is a thermal coefficient of expansion (TCE) difference between the chip and the substrate. This TCE difference creates stress in the electrical interconnections between the chip and the substrate. This is particularly significant when a chip is mounted to the substrate in a commonly used flip-chip-configuration using the C4s or solder mound to electrically interconnect chip pads to substrate pads. Use of C4s is well known in the art. C4 stress caused by TCE mismatch between chip and substrate is well known in the art. To avoid the TCE mismatch ceramics are chosen to have a TCE close to that of the semiconductor chip. The dielectric constant is about 5 for fully densified glass ceramics having a TCE closely matched to that of a silicon chip. It is preferable to use materials with dielectric constant as low as possible to increase signal speed and to minimise capacitive coupling between adjacent current carrying metal areas, in particular, between power or ground planes and signal lines and between adjacent signal lines.

It is also desirable to have electrical conductors with low resistance and low cost embedded within the ceramic modules: Copper is the preferred metal because it has low resistivity and relatively low cost. Copper however, has a melting point of about 1080°C. Therefore, sintering temperatures of ceramic modules having copper conductors must be less than the melting point of copper to avoid melting the copper lines.

Densified amorphous silicon dioxide has one of the lowest inorganic dielectric constants of about 3.8. Silicon dioxide has a sintering temperature ($\sim$ 1300°C) in excess of the melting point of copper. Also, silicon dioxide does not have a TCE matched to that of a silicon chip. Therefore, densified silicon dioxide is not suitable for a reliable substrate containing copper conductors and on which a silicon chip is electrically mounted.

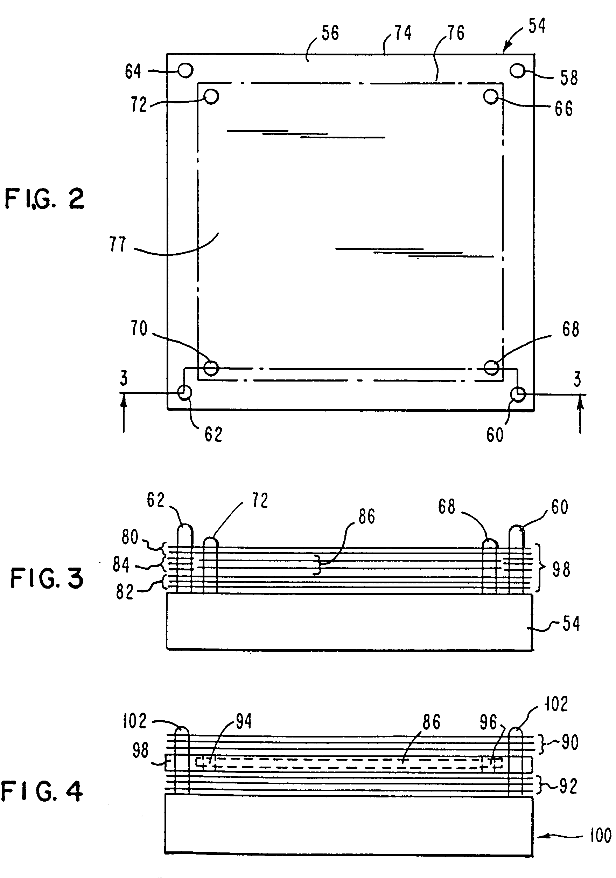

Two patents generally describing binder burn-out and the fabrication of ceramics are US -A- 4,234,367 and US -A- 4,504,339, the disclosures of both of which are incorporated herein by reference. US -A- 4,234,367 describes a method for forming sintered ceramic structures containing multi-level, interconnected circuit patterns of copper-based conductor films obtained by heating a green laminate composed of particles of crystallisable glass in an ambient of hydrogen and water to a burn-out temperature of about 700°C to 800°C at a rate of 1°C to 3°C per minute. A lower burn-out temperature would take a prohibitively excessive amount of time for carbon removal. The binder burn-out time is about 11 hours as is apparent from FIG. 4 of U -A- 4,234,367. This time is needed: 1) to avoid bloating of the ceramic article caused by entrapped volatile products which cause the article to expand instead of contracting on sintering, 2) to fully oxidise carbon in the binders, 3) to avoid drastic volume changes in the copper conductor resulting from the copper-oxide formation, and 4) to maintain reducing to neutral conditions for copper. After the binder is burned out the laminate is sintered in a neutral atmosphere to form the ceramic material by first heating to coalesce the laminate to a dense state and thereafter heating to form crystals from the densified glass particles.

US -A-4,504,399 describes a method for forming sintered ceramic structures containing multilevel, interconnected circuit patterns of copper-based conductor films from a green laminate composed of an admixture particles of glass and particles of crystallites. Binders are burned-out by firing the structure in a controlled ambient of an inert atmosphere, e.g. nitrogen, containing water vapour at a partial pressure from 0.005 to 0.3 atmospheres at a temperature between 550°C and 650°C for a time sufficient to burn out the binders in the green laminate and thereafter raising the temperature in an inert atmosphere without water to the sintering temperature to coalesce the green laminate to form the ceramic. The binder burn-out time is about 8 hours as is apparent from FIG. 2 of US -A- 4,504,399. The burn-out temperature upper boundary is limited to 650°C because if the burn-out temperature used were higher, the glass components of the green sheets would begin to coalesce hindering further binder removal.

US -A- 4,504,399 and US -A- 4,224,367 disclose burning out binders in an atmosphere sufficient to oxidise the binder but insufficient to oxidise the embedded copper conductors. It has been found that following methods such as these results in isolation of the metal patterns from the ceramic material in the fully sintered ceramic structures. Also, after thermal cycling of the fully sintered structure over the use temperatures of a semiconductor chip package substrate of about 0°C to about 85°C, these existing separations can be exacerbated and new separations, not previously existing, can occur. These separations can occur around metal lines within a metallization layer of the multilayer structure or around the metal vias which pass through the individual ceramic sheets to electrically connect conductive metal patterns on adjacent metallization layers. These separations are undesirable since they structurally weaken the multilevel metal/ceramic structure, they weaken the adhesion of the metal patterns to the ceramic material, they provide regions within which residual chemicals used in processing can accumulate as a source of contamination, and they permit the external atmosphere to penetrate the structure possibly causing corrosion therein.

US -A- 4,724,021 describes a method of inhibiting blisters during the firing of intermediate layers of fired multilayered electronic components comprising the steps of applying to a substrate a first and second layer of finely divided particles of dielectric solids and glass dispersed in organic medium firing the layers to effect volatilisation of the organic medium therefrom, and liquid phase sintering of the glass components and densification of both layers, the softening point of the glass, the particle size of the glass and the ratio of glass to dielectric solids in both layers being adjusted in such manner that when the layers are fired, the first layer is porous and the second layer is nonporous.

The US -A- 4,724,021 method forms a smooth, hermetic substantially blister-free dielectric in a ceramic hybrid multilayer circuit and, in particular, a dielectric structure which inhibits dielectric and copper blistering in ceramic hybrid multilayer circuits. The method is used to avoiding blistering or the formation of voids in copper conductors formed in the ceramic multilayer circuit. The blisters are primarily caused by premature sintering of the dielectric layer upon initial firing which traps gas generated at the interface between the dielectric layer and the underlying copper layer. The porous ceramic layer provides a region into which the gas generated in the conductors can go to avoid blistering of the copper conductor or nonporous ceramic layers. The porous layer is achieved by adjusting the softening point of the glass, the particle size of the glass and the ratio of the glass to dielectric solids in both layers in such a manner that, when the layers are fired, the sintering of the glass in the layers is such that the first layer is porous and the second layer is nonporous. The cited examples of dielectric solids are barium titanate, calcium titanate, strontium titanate, lead litanate, calcium zirconate, barium zirconate, calcium stanate, barium stanate and alumina having dielectric constants varying from 7 to thousands.

JA -A- 59-22398 describes a multilayer ceramic structure with combined layers of dense alumina and porous alumina ceramic layers. The porous layers are for lower dielectric constant and the dense layers provide strength. The metal used is tungsten. The porous layers are obtained by adding carbon particles to the ceramic and firing in a weakly oxidising atmosphere. The examples given are 30% carbon resulting in a dielectric constant of 6, and 50 to 60% carbon resulting in a dielectric constant of 5. The described structure does not include hermeticity, Cu metal, or glass ceramic material firing below 1000°C. It also does not describe pressure sintering which would densify the entire structure. The dielectric constant obtained in the structure is higher than 5.

One of the limitations of the glass ceramic module is the higher dielectric constant (5.0) of the glass ceramic material relative to that (3.5) of polymeric material such as polyimide typically used in thin film wiring. Signal transmission speed is slower in the glass ceramic and relatively thick layers are required for desirable transmission line characteristics between 50 and 70$\Omega$. In order to overcome this handicap much effort is directed toward the development of glass ceramic with lower dielectric constant. This is a difficult proposition given that the lowest dielectric constant of the well known inorganic materials is that of quartz at 3.8. To overcome this difficulty dielectric material using hollow spheres as described in D.J. Green, "Fabrication and Mechanical Properties of Lightweight Ceramics Produced by Sintering of Hollow Spheres", J. Am. Ceram. Soc., 68, III7, pp.403-409 (1985) and built in cavities in multilayer modules as described in C.M. McIntosh and A.F. Schneckenbeecher, "Low Dielectric Constant Pockets in Multi-layer Ceramic Modules", IBM Technical Disclosure Bulletin, Vol. 17, No. 3, August 1974, pp. 862-863 have been proposed. The former proposal has not been practical because of the difficulty of fabricating hollow spheres with diameters measured in microns, and the latter is difficult to implement well in a densely wired module. An added difficulty is the sintering process which must be carried out to densify the material to obtain a low dielectric constant material surrounding signal lines but with added layers of sinterable glass ceramic to obtain strength and hermeticity.

In a high performance module it would be desirable to fabricate computer cycle determining nets in the porous, low dielectric constant material while other short nets are fabricated in dense glass ceramic. In such a module the number of plane pairs of wiring allocated to cycle determining nets may be over 50%.

The object of the present invention is to provide an improved multilayer ceramic structure and a method of fabricating such a structure.

The present invention relates to ceramic structures and is characterised in that one of the layers within the structure is formed from porous silicon dioxide.

According to a preferred embodiment of the invention at least one electrical conductor extends adjacent to the surface of the silicon dioxide layer.

The invention also relates to a method of fabricating a multilayer ceramic structure comprising the steps of providing a first layer of a first green precursor to a first dielectric material, forming a cavity in the first layer, disposing a body of selected material within the cavity, sealing the cavity with a second layer of a second green precursor to a second dielectric material, and sintering the multilayer structure to form a dense structure having the selected material in sintered form sealed therein.

According to the invention the method is characterised in that the selected material is a precursor to porous silicon dioxide.

According to a preferred embodiment the method of the invention includes the step of forming at least one electrical conductor adjacent to the body of selected material.

According to one embodiment of the invention sintered ceramic substrates containing multilevel, interconnected circuit patterns of metal conductor films and porous hermetically sealed silicon dioxide regions are formed by obtaining by first disposing on a support a first green ceramic sheet, disposing on the first green ceramic sheet an annular shaped green ceramic sheet, disposing a green silicon dioxide sheet to fill in the opening of the annular sheet, and disposing a second green ceramic sheet on the annular ceramic sheet. Metal paste patterns are disposed between adjacent green ceramic sheet levels. The green composite structure is densified and sintered to form a substantially fully densified and fully sintered ceramic body containing substantially hermetically sealed therein a porous silicon dioxide region and electrical conductor patterns.

EP 0 534 733 A1

In order that the invention may be more readily understood an embodiment will now be described with reference to the accompanying drawings in which:

Fig. 1 is a diagrammatic cross-sectional view of a multi-layer packaging structure with an electronic device mounted thereon fabricated in accordance with the method described herein,

Fig. 2 is a plan view of an apparatus for performing the method described,

Fig. 3 is a cross-sectional side view of the apparatus of Fig. 2 sectioned along the line 3-3, with unlaminated green ceramic sheets and composite ceramic/porous dielectric sheets,

Fig. 4 is a cross-sectional side view of another apparatus used in performing the method described with the plurality of sheets to be laminated together thereby having the interior alignment holes to be sealed with green ceramic material,

Fig. 5 shows a plan view of another apparatus for performing the method described and shows laminated stacks of green sheets forming an annular ceramic stack with a central region of porous dielectric precursor wherein the annular stack is in a window frame shape,

Fig. 6 shows a cross-sectional view of the configuration of the apparatus of Fig. 5 sectioned along the line 6-6,

Fig. 7 is a plan view similar to that of Fig. 5 wherein the annular stack of green material is made up of four sets of rectangular parallelepiped shaped ceramic sheets,

Fig. 8 is a schematic view of pressure sintering apparatus for use in the method described,

Fig. 9 is a schematic illustration of the sintering of a glass ceramic module,

Fig. 10 is a plan view showing the dimensions of the sintering apparatus for supporting the work piece,

Fig. 11 is the temperature and pressure cycle followed in the operation of the sintering apparatus of Fig. 8,

Fig. 12 is a representation of a cross-sectional photograph of a porous silicon dioxide region embedded in a fully sintered borosilicate glass, according to the method described herein,

Fig. 13 is a representation of a cross-sectional photograph of a porous silicon oxide region embedded in a fully sintered lead borosilicate glass, according to the method described herein, and

Fig. 14 illustrates the sintering cycle used by the sintering apparatus of Fig. 8 to sinter the structures of Figs. 12 and 13.

## DETAILED DESCRIPTION

By using a method of fabrication as described herein porous silicon dioxide can be hermetically sealed within a fully densified ceramic material. A ceramic composite structure formed by the method of the present invention is useful as a substrate on which a semiconductor chip is mounted to provide electrical connection of device and circuit elements on such semiconductor chip to a support structure, such as a printed circuit board to which the substrate is electrically connected. The ceramic substrate can be a multichip substrate and can have electrical conductors formed therein from a metal based conductor forming paste containing metal particles selected from the group consisting of gold, silver, copper, molybdenum, tungsten, platinum and palladium. This list is exemplary only and not limiting.

The composite structure includes at least one green sheet formed from a thermoplastic organic binder having dispersed within the binder particles a crystallisable glass or an admixture of glass particles and crystalline particles. Commonly used ceramic binders are Butvar (registered trademark of Monsanto, Inc.) polyvinyl butyral and polyvinyl acetate. Such binders are exemplary only and not limiting. The sintering temperature of the green sheet is less than the melting point of the metal used in the metal-based metallurgical process which forms conductors within the composite structure. The sintering temperature of an admixture of glass and crystalline particles is the coalescence temperature if no further crystallisation is required or the crystallisation temperature if further crystallisation is required.

Examples of crystallisable glasses, useful for practising the method described, are disclosed in US -A- 4,301,324 and processes for making a ceramic structure are disclosed in US -A- 4,413,061 and US -A- 4,301,324. The disclosures of both these patents are incorporated herein by reference. The disclosed ceramic structures are characterised by having low dielectric constants and are compatible with circuitry of copper-based metallurgy co-sinterable therewith. These glasses have crystallisation temperature in the range of about 850°C to 970°C.

Of the two types of ceramics disclosed in the aforesaid patents US -A- 4,301,324 and US -A- 4,413,061, one has spodumene, $Li_2O.Al_2O_3.4SiO_2$, as the principal crystalline phase while the other has cordierite, $2MgO.2Al_2O_3.5SiO_2$, as the principal crystalline phase. A common feature of these sintered ceramics, among others, is their excellent sinterability and crystallisation below 1000°C.

The terms spodumene glass and cordierite glass as used herein refer to the uncoalesced and uncrystal-

5

lised glass particles. The terms spodumene ceramic and cordierite ceramic as used herein refer to the coalesced and crystallised ceramic.

The multilayered ceramic produced by the method being described includes, but is not limited to, the spodumene ceramics and cordierite ceramics as described in US -A- 4,413,061 and US -A- 4,301,324.

Other glass and ceramic materials suitable for practising the method described include but are not limited to eucryptite, borosilicate glass, lead glass, enstatite, celsian, wollastonite, willemite, anorthite, lithium disilicate, lithium metasilicate, mullite, combinations thereof and combinations thereof with alumina. This list is exemplary only and not limiting.

The following is a list of the general formula for the predominant components of the materials mentioned above:

celsian, $BaO.Al_2O_3.2SiO_2$
anorthite, $CaO.Al_2O_3.2SiO_2$
lithium disilicate, $Li_2O_6.2SiO_2$
lithium metasilicate, $Li_2.O.SiO_2$
wollastonite, $CaO.SiO_2$
willemite, $2ZnO..SiO_2$
eucryptite, $Li_2.O.Al_2O_3.2SiO_2$
mullite, $3Al_2O_3.2SiO_2$
enstatite, $MgO.SiO_2$

On the surface of the green sheet is deposited a pattern of a metal-based conductor forming composition which includes a metal paste binder, for example ethylcellulose.

A second, composite, sheet is formed from an annular shaped green sheet with the hole filled in with a silicon dioxide precursor sheet. On the surface of the second composite sheet is disposited a pattern of a metal-based conductor forming composition. The second green sheet is superimposed on the first sheet to sandwich the conductor pattern therebetween. The sheets are laminated together. A multilayered ceramic structure is formed by laminating green sheets alternately with patterns of metal-based paste between green sheets. Metal patterns separated by green sheets are connected by through-holes or vias in the green sheets which are filled preferably with the copper-based paste. For a ceramic structure for use as a semiconductor chip substrate, the metal pattern is extended to at least one surface of the composite structure. When the composite structure is fully sintered the nonsilicon dioxide green ceramic sheets and the annular sheets are sintered to a substantially fully densified ceramic material which is substantially hermetic, that is, substantially impervious to the flow of helium gas or a gas of larger molecules. The silicon dioxide precursor sheets remain porous silicon dioxide material because the sintering conditions, as described in greater detail herein below, are not sufficient to densify the silicon dioxide precursor to a fully densified material.

Any number of composite ceramic/silicon dioxide layers can be disposed within the composite structure. Some examples of configurations are: individual composite layers with electrically conducting patterns on opposite sides thereof and electrically conducting vias therethrough with ceramic layers on opposite sides thereof; stacks of composite layers with and without electrical conductor patterns therebetween; and combinations of these configurations. These are exemplary only and not limiting. The green ceramic sheets cosinter into a coherent shell which encapsulates the porous unsintered silicon dioxide on all sides.

The viscosity of the glass ceramic during sintering remains above about 9.0 poise such that adjacent glass ceramic areas are joined together but the glass ceramic does not penetrate substantially into the porous silicon dioxide structure.

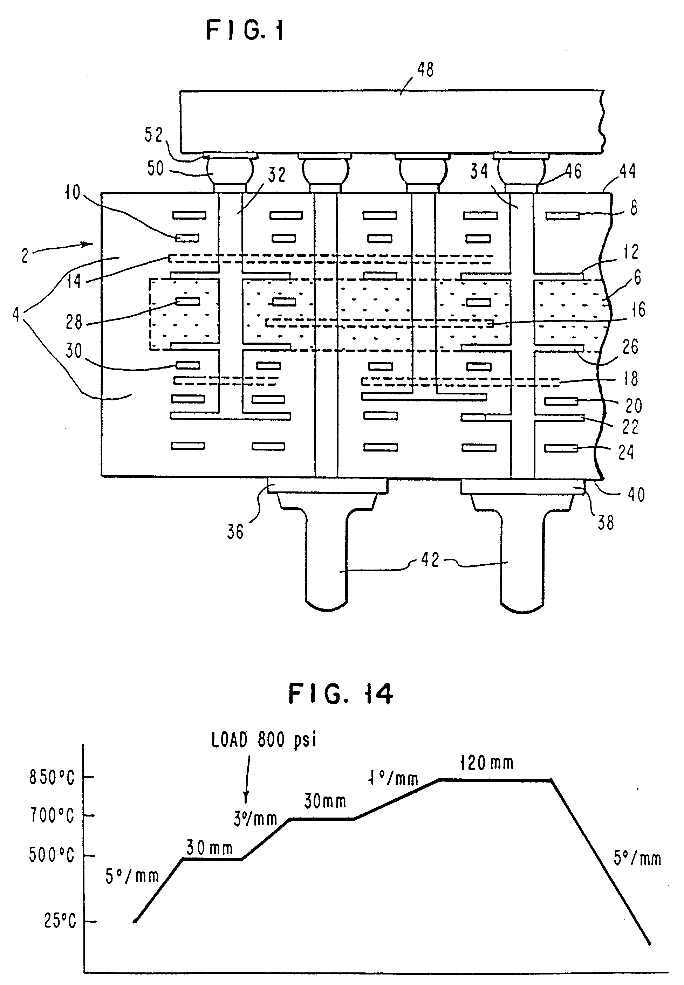

Fig. 1 shows a schematic cross-sectional view of a structure made according to the method described. Fig. 1 shows a ceramic structure 2 formed from a densified ceramic material 4 having embedded therein at least one porous dielectric layer 6 which is most preferably porous silicon dioxide. Other materials which can form porous layers are particles of AIN, $Si_3 N_4$ and SiBN. Within body 2 there are a plurality of electrical conductors, for example, 8, 10, 12, 14, 16, 18, 20, 22, 24, 26, 28 and 30. Electrical conductors can be on opposite sides of the porous layer 6, such as conductors 12 and 26, and can be embedded within the porous layer, such as 28 and 16.

Some of these electrical conductors can be reference planes, such as voltage planes and ground planes. For example, in Fig. 1 conductors 8, 12, 26, 20, 22 and 24 can be reference planes. Other electrical conductors can be signal lines such as conductors 10, 14, 28, 16, 30 and 18. Typically signal lines such as 10 and 14 are on two adjacent layers wherein the signal lines run in perpendicular directions. For example, electrical conductor 10 is coming out of the plane of the figure and electrical conductor 14 is running parallel to the plane of the figure. Also, typically, two parallel adjacent layers having orthogonal electrical conductors, commonly referred to as a plane pair, are typically disposed between two reference planes. For example, electrical conductors 8 and electrical conductors 12 bound electrical conductors 10 and 14.

Through the densified ceramic regions 4 and through the porous regions 6 can extend electrically conducting vias such as 32 and 34. Some of these vias are electrically connected to contact locations such as 36 and 38 which are shown in the form of pads extending beyond the surface 40 of composite structure 2. Electrically conducting pins 42 are typically mounted on the pads 36 and 38. However, these are not necessary. Pins 42 can be for electrical connection to a second level of packaging such as a printed circuit board. Electrically conducting vias can also extend to the top surface 44 of composite structure 2 to electrically connect to contact locations 46 which are shown in the form of pads extending beyond the surface 44 of composite structure 2. Connection means 46 are for electrical interconnection to an electronic device such as a semiconductor chip, such as, for example, a silicon chip.

In Fig. 1 electronic device 48 is shown mounted onto composite substrate 2 in a flip-chip configuration by means of solder mounds 50 which are disposed between contact locations 46 and contact locations 52 on the electronic device 48. Typically, electrical connection means 50 are mounds of solder commonly known in the art as C4s. US -A- 3,401,126 and US -A- 3,429,040 describe in detail the C4 technique of face down bonding of an integrated circuit to a substrate.

Figs. 2, 3 and 4 show an alignment apparatus for fabricating structure 2 of Fig. 1. Fig. 2 shows a plan view of the alignment apparatus 54. On the top surface 56 of alignment apparatus 54 there are a plurality of alignment pins 58, 60, 62, 64, 66, 68, 70 and 72. Alignment structure 54 in Fig. 2 has a rectangular shape 74. This is exemplary only and not limiting. Along the diagonals of square 54 there are arranged at the corners of the rectangle 74 four of the alignment pins 58, 60, 62 and 64. These are referred to as outer alignment pins. In Fig. 2 there is a rectangular shaped interior region 76 to the rectangular shape 74.

The interior 77 of rectangular region 76 is to receive sheets of precursor to the porous silicon dioxide material in the aperture of the annular region 56. Rectangular region 76 has diagonals coincident with the diagonals of rectangle 74. There are a set of interior alignment pins at the corners of the interior rectangular region 76. These alignment pins are 66, 68, 70 and 72. The outer alignment pins are for aligning green sheets of material which will be fully densified as described below. These include the green sheets which are complete layers and the green sheets which form an annular ring of material. The inner alignment pins are for aligning the precursor to the porous dielectric material which fills in the interior space of the annular ring. The annular ring can have any shape such as square, rectangular, triangular, circular and the like.

Fig. 3 shows the apparatus of Fig. 2 with green sheets disposed thereon prior to lamination and shows full green ceramic sheets 80 and 82, window frame sheets 84 and porous precursor sheets 86.

Fig. 4 shows the same arrangement of sheets as shown in Fig. 3 after the plurality of green ceramic layers and precursor porous layers have been pressed and laminated together 98 and transferred to lamination fixture 100. Numbers common between Figs. 4 and 3 represent the same items. The porous layers 86 are located within the prelaminated stack 98.

As shown in Fig. 3 the frame sheets 84 are added as compensating layers during the green laminating process. In the green stacking process as shown in Figs. 3 and 4 compensating frame sheets of glass ceramic are added as needed to ensure a dense edge upon sintering. Generally, a greater thickness is needed for the annular region than for the porous region since the annular region shrinks more when it becomes fully densified. Two sets of alignment pins as described above enable stacking of sheets with other compensating frame sheets. In a second alignment step, as shown in Fig. 4, additional glass ceramic sheets 90 and 92 without the alignment holes 94 and 96 made for pins 72 and 66 respectively of Fig. 3 are laminated to the porous sheet stack 98 to seal the inner alignment holes.

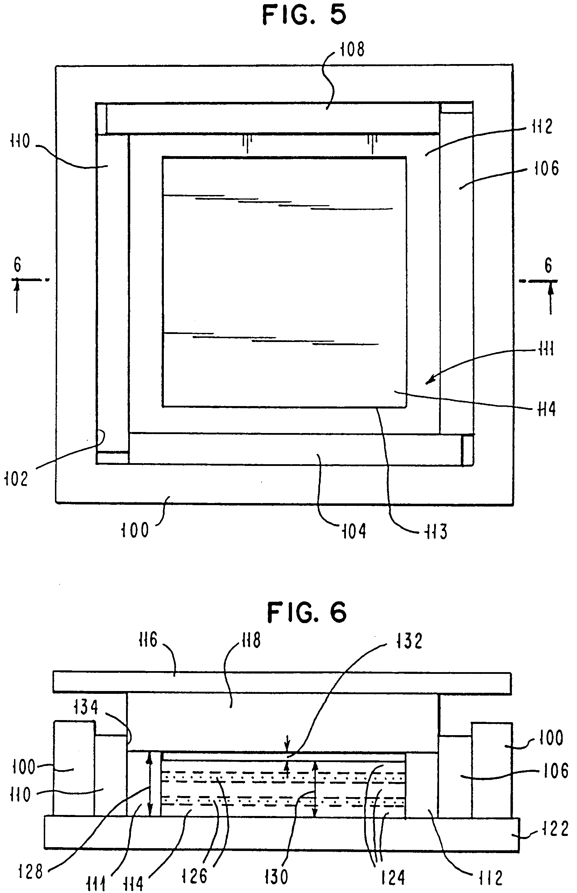

An alternative way to fabricate the hermetic sintered substrate is by hot pressing an inner laminated stack containing porous layers with a second laminated stack of ceramic layers in the shape of a window frame, as shown in Figs 5 and 6. The inner stack containing the porous layers is made by laminating the green sheets of ceramic and porous dielectric layers as desired and cutting the laminated stack to the desired dimensions.

Similarly, the window frame stack is formed by laminating green ceramic sheets from which the central portion is blanked or cut out.

Fig. 5 is a plan view of a hot pressing apparatus with the top two plates removed and having an outer constraint frame 100 preferably of molybdenum which has an inner edge 102. Within the outer constraint frame 100 there are located temperature compensating inserts 104, 106, 108 and 110. The function of these inserts will be described in greater detail herein below. On the interior of the temperature compensating inserts is disposed a window frame shaped laminated, cut and burnt off stack 111 of sheets, the top one of which is shown as 112. In the interior of the window frame shape stack 111 as defined by edge 113 is a similarly laminated, cut and burnt off stack 114 of a plurality of sheets some of which are precursors of densified green ceramic material and others of which are precursors of porous dielectric material.

Fig. 6 shows the apparatus of Fig. 5 sectioned along the axis 6-6 of Fig. 5. Fig. 6 has, in addition to what is shown in Fig. 5, top hot pressing plates 116 and 118 which are preferably made of molybdenum.

Numbers common between Fig. 6 and Fig. 5 represent the same item. The edge constraint frame 100 and the temperature compensating inserts 104, 106, 108 and 110 are disposed on the bottom plate 122 of the hot pressing apparatus of Fig. 6. The stack of sheets 114 on the interior of edge 113 is made up of a plurality of ceramic layers 124 and at least one precursor 126 of porous dielectric layers. Stack 111 is made up of a plurality of window frame shaped layers. The thickness 128 of the window frame shaped layers is larger than the thickness 130 of the stack 114 of ceramic precursor layers and dielectric layers. The stack 111 of window frame shaped members upon densification shrinks more than the inner stack 114 of ceramic precursor layers and porous dielectric layers. As the glass ceramic frame shrinks under pressure and temperature, the air gap 132 between the top plate 118 and the inner stack 114 is eliminated and pressure is then applied to both interior stack 114 and frame stack 111. The inner stack 114 containing the porous dielectric and the frame stack 111 then shrink vertically together to form a unified module with all joints bonded together. The top plate 118 is slidably mounted between the inner edge 134 of member 110 by a layer of alumina (or other high temperature material) which is sprayed or pressed on as a green sheet to the sliding surface of the top plate 118.

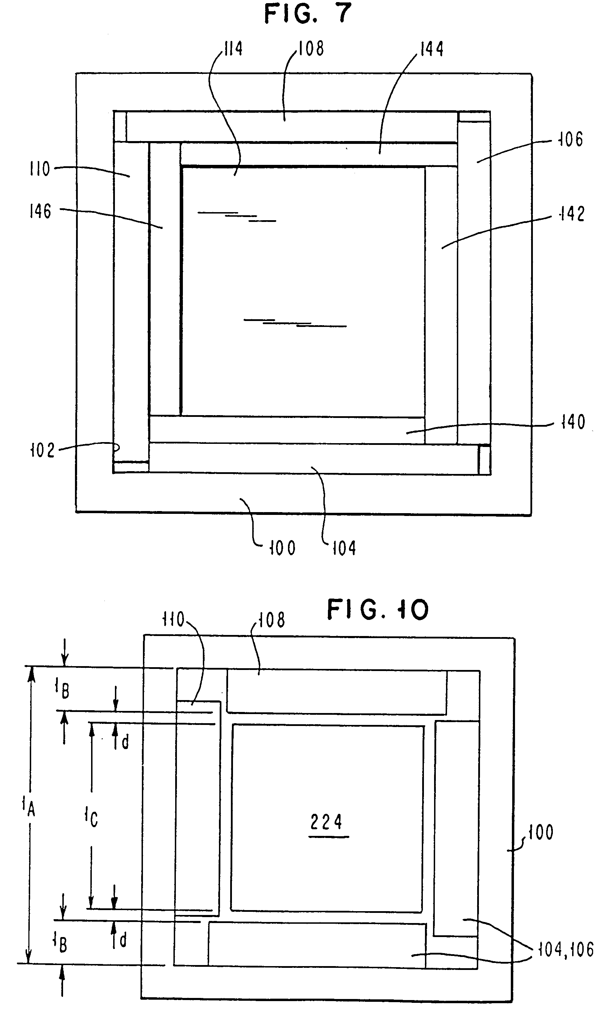

As shown in Fig. 1 stack 111 may be formed of stacks of rectangular parallelepiped ceramic sheets 140, 142, 144, 146 cut to the desired dimensions as shown in Fig. 7 and burned off. Numbers common between Figs. 7 and 5 represent the same items.

Prior to hot pressing, the laminated structure is heated to the burn-out temperature at a rate which does not disturb the integrity of the substrate. If burn-out is too rapid, plasticisers contained in the binder in the green sheets will come off too rapidly causing blisters and resulting in delamination of the green laminate. The laminate is maintained at the burn-out temperature for a sufficient time to decompose and eliminate the binders in the green sheets and metal-based paste. The temperature must not be high enough to melt the metal-based conductor pattern and must not be high enough to cause coalescence of the glass particles. A requirement for binder removal is that the ceramic body remain porous until all carbon residues are removed. If the glass particles in the green laminate begin to coalesce before the binders are burned-out, the products of the binder decomposition become trapped in the ceramic: 1) leaving carbon residues which increase the ceramic dielectric constant, 2) forming pores in the glass ceramic preventing its complete densification and 3) delaminating the green laminate if the pressure of the trapped products is great enough.

Examples of glass ceramic materials which may be used to form the glass ceramic body 10 are given in US -A- 4,234,367 and US -A- 4,301,324, the disclosures of which are incorporated by reference herein. Cordierite glasses, mullite glasses, or other glasses which can be heated to crystallisation can also be used. Mixtures of noncrystallising glasses and ceramics may also be used. For purposes of illustration, and not of limitation, several glass ceramic compositions that may be used according to the method being described are listed in Table I.

EP 0 534 733 A1

## TABLE I

### GLASS CERAMIC COMPOSITIONS (WEIGHT PERCENT)

| | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| $SiO_2$ | 55.0 | 54.5 | 54.5 | 52.3 | 57.8 | 60.0 | 50.0 | 53.9 | 54.0 | 55.0 | 60.0 | 54.5 | 57.0 | 55.0 | 47.0 | 53.9 | 54.0 | 54.5 | 54.0 | 54.0 |
| $Al_2O_3$ | 21.1 | 21.0 | 21.0 | 19.7 | 22.2 | 18.2 | 22.9 | 20.7 | 21.0 | 21.0 | 17.0 | 20.0 | 21.0 | 21.0 | 33.5 | 20.8 | 22.0 | 21.3 | 22.0 | 21.0 |
| $MgO$ | 22.3 | 19.8 | 19.8 | 24.0 | 16.0 | 17.8 | 22.2 | 19.6 | 19.0 | 18.0 | 18.0 | 20.0 | 20.0 | 22.0 | 13.5 | 19.6 | 20.0 | 19.9 | 20.0 | 22.0 |
| $B_2O_3$ | 1.2 | 1.0 | 1.0 | 1.0 | 1.0 | 1.0 | 1.1 | 1.0 | 1.0 | 1.0 | 1.0 | 1.0 | 1.0 | 2.0 | 3.0 | 1.0 | 1.0 | 1.0 | 1.0 | 1.0 |
| $P_2O_5$ | 0.3 | 2.7 | 2.7 | 3.0 | 3.0 | 3.0 | 1.8 | 2.8 | 3.0 | 3.0 | 3.0 | 1.5 | 1.0 | | 3.0 | 2.7 | 2.0 | 2.8 | 2.0 | |
| $CeO_2$ | | 1.0 | | | | | | | | | | | | | | | | | | |
| $MnO$ | | | 1.0 | | | | | | | | | | | | | | | | | |
| $ZrO_2$ | | | | | | | 2.0 | | | | | 2.0 | | | | | | | | |
| $CaO$ | | | | | | | | | 2.0 | | | 1.0 | | | | | | | | |
| $NiO$ | | | | | | | | | | 2.0 | | | | | | | | | | |
| $Li_2O$ | | | | | | | | | | | 1.0 | | | | | | | | | |
| $Fe_2O_3$ | | | | | | | | | | | | | | | | 2.0 | | | | |
| $Na_2O$ | | | | | | | | | | | | | | | | | 1.0 | | | |
| $TiO_2$ | | | | | | | | | | | | | | | | | | 1.0 | | |
| $ZnO$ | | | | | | | | | | | | | | | | | | | 1.0 | |
| $CuO$ | | | | | | | | | | | | | | | | | | | | 2.0 |

Pressure sintering or pressing without edge constraint as can be used for the laminate structure shown in Fig. 4 is described in detail herein below.

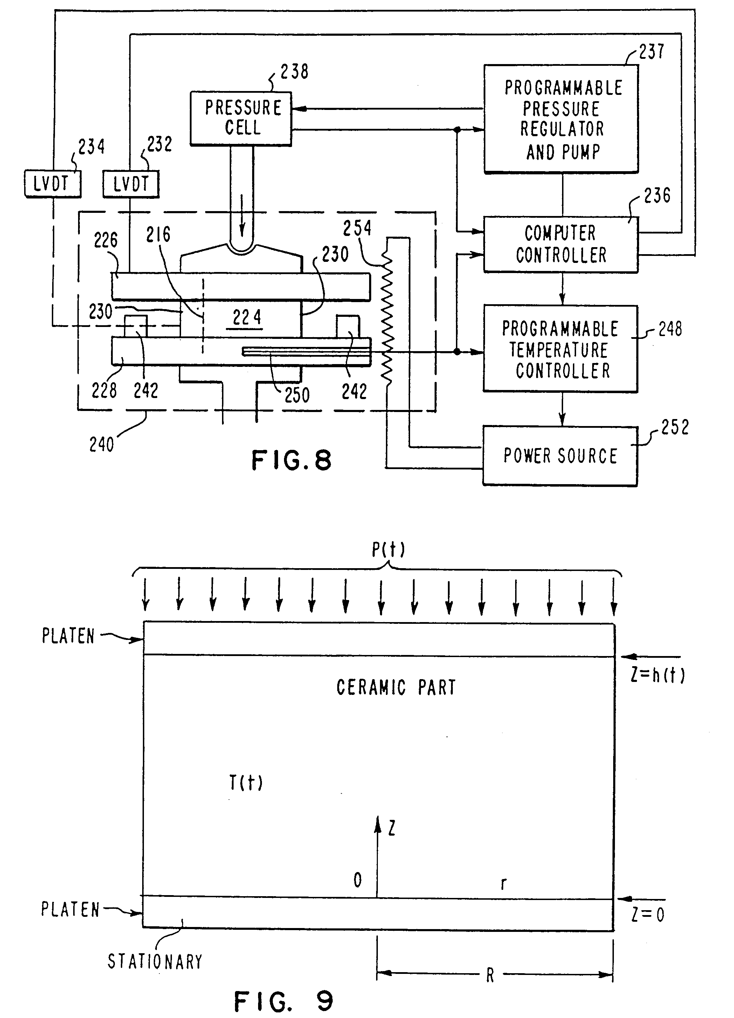

Apparatus which can be used to implement the above described method is shown in Figure 8. The workpiece 224 is compressed between upper die 226 and lower die 228.

While the workpiece 224 is compressed between dies 226 and 228, it is important that the edges 230 of the workpiece 224 are not deformed. Therefore, means 232 are provided for measuring the thickness of the workpiece, means 234 are provided for measuring the width or edge bulge 230 of the workpiece, and means 236, 237 and 238 are provided for varying the pressure on the workpiece as a function of the measured thickness and as a function of the measured edge bulge (or width) of the workpiece. The means 232 and 234 for measuring the thickness and edge of the workpiece may be linear variable displacement transducers (LVDT's). The pressure controller 236 may be, for example, a general purpose digital computer for controlling a programmable pressure regulator and pump 237, which in turn applies pressure to workpiece 224 by way of pressure cell 238 which may be a hydraulic press. The workpiece 224 and the dies 226 and 228 are arranged inside a furnace 240, schematically illustrated.

A programmable temperature controller 248 controls the sintering temperature according to a preselected temperature schedule. Temperature controller 248 measures the furnace temperature by way of thermocouple 250, and regulates the furnace temperature by way of power source 252 and heater element 254.

Deformation of the edges 230 of the workpiece 224 may be avoided during pressure sintering by varying the pressure as a function of the thickness, edge bulge, and relative density of the workpiece. This functional relationship can be derived in the following manner.

Consider the sintering of a circular, porous glass ceramic module (Figure 9) of initial density, $\rho o$, initial thickness, $h_o$, and constant radius, R, under a pressure schedule P [t] and a temperature schedule T[t] where t is the time elapsed after the start of the experiment.

For the sintering of ceramics, the Reynolds number of the flow is so small (due to the very high glass viscosities, e.g., $> 10^9$ poise for the glass ceramic used in the method being described) that the inertia terms in the equations of motion are negligible. Also, because the aspect ratio, R/h (h being the thickness of the module at any time t), is typically much greater than unity, the two flow velocities, $V_r$ and $V_z$, satisfy the simplified Navier-Stokes equation

$$\frac{dp[r]}{dr} = \eta \left(\frac{\partial^2 Vr[r,z]}{\partial z^2}\right) \quad (1)$$

and the continuity equation

$$\frac{1}{r}\frac{\partial}{\partial r}(rV_r) + \frac{\partial V_z}{\partial z} = -\frac{\dot{\rho}}{\rho} \quad (2)$$

based on the assumption that the glass ceramic is a Newtonian substance. In Equations 1 and 2, r and z signify the lateral and axial directions shown in Figure 9, p is the dynamic pressure defined as the pressure above the ambient, $\eta$ is the viscosity, and $\rho$ is the module density which is assumed to vary only with time. The viscosity can depend on temperature, and time if crystallisation is involved (see Equation 6 below).

The initial and boundary conditions associated with Equations 1 and 2 are typical of squeeze-flow situations:

$$\rho = \rho_0 \text{ at } t = 0 \quad (3a)$$
$$h = h_0 \text{ at } t = 0 \quad (3b)$$
$$V_z = 0 \text{ at } Z = 0 \quad (3c)$$
$$V_z = h = \frac{dh}{dt} \text{ at } Z = h \quad (3d)$$
$$V_r = 0 \text{ at } z = 0,h \quad (3e)$$
$$P = 0 \text{ at } r = R \quad (3f)$$

$$\pi R^2 \rho = 2\pi \int_0^R \rho r \, dr \quad (3g)$$

The mathematical system defined by Equations 1-3 contains two unknowns, namely, the viscosity, $\eta$, and the density, $\rho$. To determine the density variation with time during sintering, an expression covering a wide range of pressures has been proposed by Murray et al. ("Practical and Theoretical Aspects of the Hot Pressing of Refractory Oxides,"; Transactions British Ceramic Society; Volume 53, 1954, pages 474-510) for moulding applications:

$$\frac{dD}{dt} = (\frac{4\pi}{3})^{\frac{1}{3}} \frac{3\gamma n^{\frac{1}{3}}}{2\eta} (1-D)^{\frac{2}{3}} D^{\frac{1}{3}} \left[ 1 + \frac{P}{2\gamma n^{\frac{1}{3}}} (\frac{1-D}{D})^{\frac{1}{3}} (\frac{3}{4\pi})^{\frac{1}{3}} \right] \qquad (4)$$

where $D = \rho/\rho_f$, $\rho_f$ is the fully sintered density, $\gamma$ is the surface tension, and n is the number of pores per cm$^3$ of the module which is intimately related to the particle size of the module. For the glass ceramics used in the method being described, $\gamma \sim 360$ dynes/cm (Giess et al.) J. Amer. Ceram. Soc1984, Vol. 67, pages 549, and n is assumed to be identical to that reported by Murray et al., (i.e., n = 1.58 x 10$^8$/cm$^3$) due to lack of data.

Equation 4 is used to calculate the density under either isothermal or dynamic heating conditions with the understanding that both the pressure and viscosity can vary with time. Because the local pressure effective for sintering is the hydrodynamic pressure which varies in the lateral direction, r, due to the absence of a die, p in Equation 4 is replaced with the effective pressure

$$\tilde{P} = \frac{\int_0^R P \, dr}{R} \qquad (5)$$

which will be evaluated later.

In a manner analogous to that occurring during curing of a polymer, the viscosity $\eta$ of a glass ceramic can be represented by the dual-Arrhenius expression (Roller, M.B. "Characterisation of the Time-Temperature-Viscosity Behaviour of Curing B-Staged Epoxy Resin", Polymer Eng. Sci., June 1975, Vol. 15, No. 6, pages 406-414):

$$\ln \eta [t,T] = \ln \eta_\infty + \frac{\Delta E \eta}{R'T} + k_\infty \int_0^t exp \left[ \frac{-\Delta E_k}{R'T} \right] dt \qquad (6)$$

where R$^1$ is the universal gas constant and $\eta_{oo}$, $\Delta E\eta$, $K_{oo}$ and $\Delta Ek$ are constant parameters. This expression accounts for both an exponential viscosity decay with temperature due to softening of the glass (first two terms on the right-hand side), and a linear viscosity increase due to crystallisation according to first-order kinetics (the last term on the right-hand side).

It must be noted that the last two terms on the right-hand side require knowledge of the thermal history of the module for their evaluation. Thus, even two fluid elements having the same temperature at some time could have very different viscosities if their temperatures at previous times were not identical.

Whenever a temperature non-uniformity exists in the ceramic module the trajectory of each fluid element must be evaluated, in general, to determine the spatial distribution of the viscosity of the glass ceramic. This can be done, in principle, by solving the energy conservation equation together with the equations of motion for a given set of initial and boundary conditions. In this description it is assumed that the viscosity at a given time does not depend on position or, equivalently, the temperature which governs the viscosity is uniform.

The parameters in Equation 6 can be obtained by, for example, performing some isothermal parallel-plate rheometry experiments at temperatures covering the temperature range of interest using reasonable non-porous samples (see Tong et al. "Prediction of Thermoset Viscosity Using a Thermomechanical Analyzer" Journal of Applied polymer Science, 1986, Vol. 31, pages 2509-2522). Once the parameters are known, Equation 6 can be used to predict the viscosity history under a wide variety of temperature schedules. When the effect of crystallisation on the viscosity has not been established fully, it is necessary to resort to the viscosity-temperature relationship up to some maximum temperature where the crystallisation effect is likely to become important.

Solving for the mathematical system (Equations 1-3), we obtain

$$\dot{h} = \frac{-2Ph^3}{3R^2 \eta} - \frac{h\dot{\rho}}{\rho} \qquad (7)$$

indicating that the sample thickness, h, is controlled by the competition between a lamination flow term (first term on the right-hand side) which is proportional to the ratio of the applied pressure, P, to the sample cross sectional area, $A(=\pi R^2)$, and a sintering flow term (second term on the right-hand side) which depends on the pore closing pressure (or the applied pressure) but not on the sample area. Therefore, when the lamination flow term is dominating, the thickness can be expected to depend on the pressure to area ratio. On the other hand, when the sintering flow term dominates, the thickness is insensitive to the sample area. Accompanying Equation 7 are $\widetilde{P}$ =4P/3 and the velocity profiles

$$Vz = -\frac{z}{\rho}\dot{\rho} - \frac{2P}{3R^2\eta}Z^2(3h - 2z) \quad (8)$$

$$Vr = -\frac{2Pr}{R^2\eta}(z^2 - zh) \quad (9)$$

The expression for $V_z$ contains a sintering or density contribution (first term on the right-hand side) and a lamination contribution. The sintering contribution disappears in the expression for $V_r$, i.e., the lamination flow. This is due to the much smaller sintering flow in the lateral direction compared to that in the thickness direction - a direct manifestation of immobile module surfaces. According to $V_r$ alone, the edge always bulges outward. This is inconsistent with the shrink-in edge observed at low pressures (e.g., <5 psi.) for glass ceramics used in the method being described. The discrepancies here were due to the increasing importance of the lateral sintering flow at low pressures. No expression is yet available to describe this retarded sintering flow in the lateral direction. As an approximation, we assume that, at the centre between the two surfaces of the module (i.e., at z = h/2 and r = R), the material sinters or shrinks in accordance with the free sintering law at a speed, $\lambda$, where

$$\lambda = -\frac{R}{2}(\frac{\gamma n_3^{\frac{1}{3}}}{\eta})(\frac{4\pi}{3})\frac{1}{3}(\frac{1}{D} - 1)\frac{2}{3} \quad (10)$$

If the edge is allowed to shrink conformally (i.e. at all z's) according to Equation 10 instead of just at the centre (i.e., if $\lambda = \dot{R}$ with R now varying with time) and if Equation 10 also governs the thickness changes (i.e., $\lambda = h$), then Equation 10 is equivalent to Equation 4 with P=O. With $\lambda$ the edge bulge, $\theta$, is given by

$$\theta = \int_0^t (V_r - \lambda)\,dt \quad at \; Z = \frac{h}{2} \; , \; r = R \qquad (11)$$

Depending on the sign of $\theta$, the edge either bulges outward ($\theta > 0$) or shrinks inward ($\theta < 0$). According to Equation 11, the condition for a flat edge ($\theta = 0$) rests upon setting $V_r = \lambda$ at all rimes. This yields the pressure schedule

$$P = \gamma n_3^{\frac{1}{3}}(\frac{4\pi}{3})\frac{1}{3}(\frac{1}{D} - 1)\frac{2}{3}\frac{(R_0 + \frac{\theta}{2})^2}{h^2} \quad (12)$$

where $R_o$ is the initial radius of the workpiece. From Equation 12, it can be seen that the pressure schedule required for a flat edge depends on the thickness, h, the edge bulge, $\theta$, and the relative density, D.

Thus, in the apparatus of Figure 8, the LVDT 232 measures the thickness of the workpiece 224, and the LVDT 234 measures the width or edge bulge of the workpiece 224. The relative density D is calculated by controller 236 based on the known mass of the workpiece and on the measurements of h and $\theta$.

Pressure controller 236 varies the pressure on the workpiece 224 as a function of the measured thickness, the measured edge bulge, and the relative density of the workpiece according to the pressure schedule of Equation 12.

When the measured edge bulge $\theta$ exceeds a selected limit, controller 236 releases the pressure on workpiece 224. This allows free sintering to reduce the edge bulge. When the edge bulge is back within the selected limit, the pressure is reapplied according to Equation 12. When the desired sample thickness is reached, controller 236 releases the pressure for the remainder of the process.

Edge deformation can also be minimised by providing stops 242 between the dies 226 and 228 (Figure 8). By compressing the workpiece 224 until the upper die 226 contacts the stops 242 and the workpiece has a selected thickness, edge deformation can be minimised.

It is important to avoid edge deformation in hermetic packages containing vias, because edge deformation is also associated with via deformation. Consequently, when edge deformation is avoided, then via deformation is also avoided. Deformed vias will not properly align with either termination pads deposited on the tops of the vias, or electrical contacts on electronic components to be mounted on the hermetic package.

As shown in Figure 8, when the edges 230 of the workpiece 234 are supported only by the workpiece itself in a direction transverse to the axis 216 of the workpiece, edge deformation is avoided by suitably controlling the pressure on the workpiece.

In another arrangement, however, the sintering apparatus is provided for supporting the edges 230 of the workpiece. Referring to Figures 5, 6 and 7, the sintering apparatus comprises a frame 100 and compensating inserts 104, 106, 108, 110 arranged inside the frame 100. The compensating inserts 104, 106, 108, 110 and the frame 100 bound a sintering chamber for accommodating the workpieces 112 and 114 in Fig. 6 and the workpieces 114, 104, 106, 108, 110 in Fig. 7. The bottom of the sintering chamber is formed by the lower die 122 of Figure 6, and the top of the sintering chamber is formed by the upper die 118.

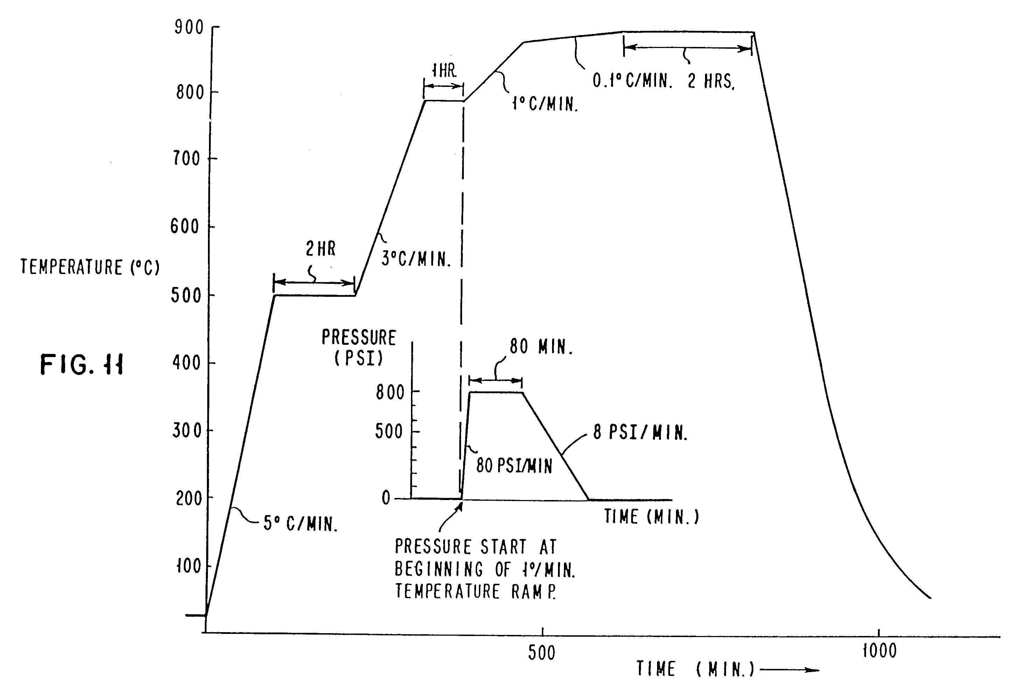

The dimensions of the sintering apparatus are shown in Figure 10. As shown therein, the frame 100 has a length $l_a$ in a first direction. Compensating inserts 104, 106, 108, 110 have lengths $l_b$ in the first direction. The workpiece 224 consisting of inner 114 and frame 111 stacks has a length $l_c$ in the first direction. In order to be able to easily remove the sintered workpiece 224 from the fixture after firing, and in order to avoid crushing or distorting the workpiece on cooling after the pressure sintering, two small gaps having lengths d are provided between the inside of the apparatus and the workpiece at room temperature. The thermal expansion coefficients of the frame, the compensating insert, and the workpiece are $\alpha_A$, $\alpha_B$ and $\alpha_C$, respectively.

The desired gaps between the workpiece 224 and the sintering fixture can be provided on cooling the sintered workpiece to room temperature if the following relationships hold.

$$l_A\alpha_A\delta T = 2l_B\alpha_B\delta T + l_C\alpha_C\delta T - 2d, \quad (13)$$

and

$$l_A = l_C + 2l_B + 2d, \quad (14)$$

where $\delta T$ is the change in temperature of the sintering apparatus and workpiece. The dimensions $l_A$, $l_B$, $l_C$ and d are all taken at room temperature.

Substituting Equation 14 into Equation 13 (and recognising that $\alpha_A \delta T$ is much less than 1 for sintering in the range of 1000 C) yields;

$$2l_B = \frac{(\alpha A - \alpha C)}{(\alpha B - \alpha A)} l_C + \frac{2d}{(\alpha B - \alpha A)\delta T} \quad (15)$$

The same relationship can be used to ensure a close fit between the workpiece 24 and the sintering apparatus at all temperatures in a direction perpendicular to $l_A$, $l_B$, and $l_C$.

In order to obtain the best results, the sintering apparatus should be made of materials which resist oxidation and which resist adhering to the workpiece. For example, the sintering apparatus may be made of molybdenum. The compensating inserts may be, for example, copper, nickel, or stainless steel. A release coating such as alumina powder may be provided on surfaces of the apparatus which contact the workpiece.

The operation of the sintering apparatus is as follows. On heating, the frame 100 expands more than the workpiece 224. However, the compensating inserts 104, 106, 108, 110 expand more than frame 100 so as to eliminate gap d at the sintering temperature. On cooling, the compensating insert shrinks more than frame 100 so the gap d reappears.

The method described will become more clear after referring to the following examples.

Example 1

A crystallisable (cordierite) glass as disclosed in US -A- 4,301,324 was ground into a powder.

The crystallisable glass powder was mixed with a binder of Butvar (trademark of Monsanto Company), a polyvinybutyral resin, dipropylglycol-dibenzoate plasticizer, and methanol/methyl isobutylketone solvent to form a slurry.

The slurry was cast into green sheets on a Mylar (trademark of El du Pont de Nemours Company) substrate by doctor blading, followed by drying in air. The dry green sheets were blanked to required dimensions, and via holes were punched in desired configurations.

In a similar manner, dry green sheets consisting of an approximate mixture of 90% alumina and 10% glass as described in the article by A. J. Blodgett and D. R. Barbour entitled, "Thermal Conduction Module: A High Performance Multi-Layer Ceramic Package", published in IBM Journal of Research and Development, Vol. 26, No. 1, January 1982, Page 32, were fabricated, blanked and punched. These sheets later serve to form the porous dielectric layers since they do not densify at the sintering temperature of the crystallisable glass.

Metallization paste was screen printed onto the cut green sheets to fill the via holes. The metallizing paste was formed by mixing copper powder with a crystallisable glass powder as described above. The copper and glass mixture was also provided with a binder of ethyl cellulose and terpineol.

A first metallizing paste contained 55 volume % copper. A second metallization paste contained 100 volume % copper.

Samples were produced by stacking and laminating 47 green sheets in the following order: 10 crystallisable glass sheets, 25 alumina sheets and 12 crystallisable glass sheets. These samples form the interior portion of the finished modules.

Samples were also prepared by laminating 70 unmetallised green sheets of crystallisable glass. These 70 layer laminated stacks were cut into rectangles 131 mm by 9 mm. They later serve as edge pieces around the interior portion to hermetically seal the module after hot pressing.

The laminated assemblies were heated in an $H_2/H_2O$ atmosphere to burn out polymeric material and residual carbon. The burnout was performed by heating at 1-3°C per minute to 785 ± 10°C, and holding at that temperature for 3-5 hours. The ratio of $H_2$ to $H_2$ O started at $10^{-6}$, and was changed continuously to $10^{-4}$ from 400°C to the burnout temperature. Thereafter, the atmosphere was changed to $N_2$ to remove dissolved water, and the assemblies were cooled to room temperature at 5°C per minute.

The burnt off assemblies were then arranged in a sintering apparatus as shown in Fig. 7 and sintered in a nitrogen-rich atmosphere of hydrogen and nitrogen as shown in Fig. 11. The temperature of the sintering apparatus with properly arranged burnt off assemblies was raised by 5°C per minute to 500°C. After holding the temperature at 500°C for 2 hours, the temperature was raised at 3°C per minute to 790°C and held for one hour.

Immediately after the initiation of the compression at 0.55 pascals (80lbs. per square inch) to 5.5 pascals (800 psi), the temperature was raised 1°C per minute to 870°C then 0.1°C per minute to 895°C. The pressure was maintained at 5.5 pascals (800 psi) for 80 minutes then reduced at 0.055 pascals (8 psi) per min. to 0 pascals.

Finally, after two hours at 890°C, the temperature was decreased 5°C per minute down to room temperature.

The structural integrity of each substrate was inspected under a microscope to ensure that no crack is present.

## EXAMPLES 2 AND 3

Other compatible sets of materials from which multilayer modules with Cu metallization may be fabricated by the processes illustrated herein were investigated. The interior embedded particles are illustrative of the porous dielectric medium and the outer shell that of the dense glass ceramic substrate.

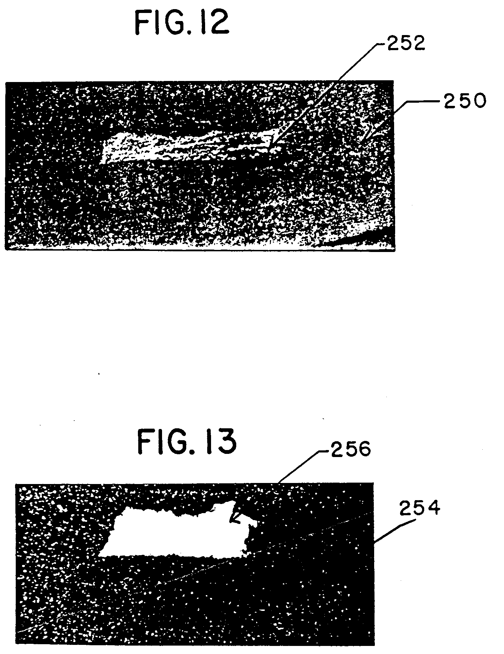

Fig. 12 shows Corning 7052 borosilicate glass/alumina mixture, 250, with a region, 252, of porous silicon dioxide embedded therein. Corning 7052 has approximate composition 64%. $SiO_2$, 8% $Al_2O_3$, 19% $B_2O_3$, 1% $Na_2O$, 3% $K_2O$, 3% BaO, the remaining being F- and other residual material.

Fig. 13 shows densified Corning 7720 lead borosilicate glass/alumina mixture, 254, with a region, 256, of porous silicon dioxide embedded therein. Corning 7720 has an approximate composition, 74% $SiO_2$, 1% $Al_2O_3$, 15% $B_2O_3$, 4% $Na_2O$, and 6% PbO.

Disk shaped pellets were pressed from powder mixtures of 50% by weight Corning 7052 and (50% by weight) alumina and from powder mixtures of Corning 7720 50% by weight and 50% by weight of alumina. A cavity was formed in one pellet and filled with the porous silica precursor. Another pellet was placed over the cavity to form a sealed pellet. The sealed pellet was pressure sintered as described herein above according to the sintering cycle of Fig. 14. The borosilicate/alumina mixture was sintered in forming gas. The Pb-borosilicate glass was sintered in nitrogen.

## Claims

1. A multilayer ceramic structure (2) characterised in that one of the layers (6) within said structure is formed from porous silicon dioxide.

2. A ceramic structure as claimed in Claim 1 characterised in that at least one electrical conductor (12, 26) extends adjacent to the surface of said porous silicon dioxide layer (6).

3. A ceramic structure as claimed in either of the preceding claims characterised in that at least one electrical conductor (28) extends through said porous silicon dioxide layer (6).

4. A ceramic structure as claimed in any one of the preceding claims characterised in that at least one of said layers (80, 82, 84) is formed from a dielectric material which is an aggregate of randomly oriented crystallites.

5. A ceramic structure as claimed in Claim 4 characterised in that the interstices between said crystallites contain uncrystallised material.

6. A method of fabricating a multilayer ceramic structure comprising the steps of

providing a first layer (84) of a first green precursor to a first dielectric material,

forming a cavity in said first layer,

disposing a body (86) of selected material within said cavity,

sealing said cavity with a second layer (80, 82) of a second green precursor to a second dielectric material, and

sintering said multilayer structure to form a dense structure having said selected material in sintered form sealed therein,

characterised in that said selected material is a precursor to porous silicon dioxide.

7. A method of fabricating a multilayer ceramic structure as claimed in Claim 6 characterised in that said first green precursor is an aggregate of randomly oriented crystallites.

8. A method of fabricating a multilayer ceramic structure as claimed in Claim 6 or Claim 7 characterised in that said second green precursor is an aggregate of randomly oriented crystallites.

9. A method as claimed in Claim 7 or Claim 8 characterised in that the interstices of said random oriented crystallites contain uncrystallised material.

10. A method as claimed in any one of Claims 6, 7, 8 or 9 characterised by the step of forming at least one electrical conductor (12, 26) adjacent to said body of selected material.

# FIG. 1

# FIG. 14

EP 0 534 733 A1

FIG. 2

FIG. 3

FIG. 4

17

# FIG. 5

# FIG. 6

# FIG. 7

# FIG. 10

FIG. 8

FIG. 9

FIG. 11

# FIG. 12

252

250

# FIG. 13

256

254

EP 0 534 733 A1

**European Patent Office**

## EUROPEAN SEARCH REPORT

 Application Number

EP 92 30 8661

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 196 865 (IBIDEN)<br>* claims 1,2; figure 3 *<br>--- | 1-3 | H01L23/498<br>H01L23/15 |
| A | EP-A-0 202 858 (HITACHI)<br>* claim 1 *<br>--- | 1-6,9,10 | |
| A | EP-A-0 411 639 (IBIDEN)<br>* claims 1,6; figure 16 *<br>--- | 1-4,6,10 | |
| A | WO-A-8 907 834 (UNISYS)<br><br>----- | | |

|  |
|---|
| TECHNICAL FIELDS SEARCHED (Int. Cl.5) |
| H01L |

The present search report has been drawn up for all claims

| Place of search | Date of completion of the search | Examiner |
|---|---|---|
| THE HAGUE | 28 DECEMBER 1992 | DE RAEVE R.A.L. |

 CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

23